# EUROPÄISCHE PATENTSCHRIFT

(11) **EP 0 972 434 B1**
(45) Veröffentlichungstag und Bekanntmachung des Hinweises auf die Patenterteilung: **06.02.2002**
(21) Anmeldenummer: 98919035.0
(22) Anmeldetag: 05.03.1998
(51) Int. Cl.: H05K 9/00

(54) **VORRICHTUNG ZUM BEFESTIGEN EINES SCHIRMDECKELS**
DEVICE FOR FASTENING A PROTECTIVE COVERPLATE
DISPOSITIF POUR FIXER UN COUVERCLE DE BLINDAGE

(30) Priorität: 27.03.1997 DE 29705621 U
(43) Veröffentlichungstag der Anmeldung: 19.01.2000
(73) Patentinhaber: SIEMENS AKTIENGESELLSCHAFT, 80333 München (DE)
(72) Erfinder: GAHL, Andreas, D-81369 München (DE)
(86) Internationale Anmeldenummer: DE9800655
(87) Internationale Veröffentlichungsnummer: WO9844770

(56) Entgegenhaltungen:
- DE-U- 6 607 180
- FR-A- 2 682 005
- PATENT ABSTRACTS OF JAPAN vol. 096, no. 009, 30. September 1996 & JP 08 116195 A (MATSUSHITA ELECTRIC IND CO LTD), 7. Mai 1996
- PATENT ABSTRACTS OF JAPAN vol. 097, no. 005, 30. Mai 1997 & JP 09 027358 A (NEC SHIZUOKA LTD), 28. Januar 1997

## Beschreibung

Die vorliegende Erfindung betrifft eine Vorrichtung zum Befestigen eines Schirmdeckels auf einem abzuschirmenden Bereich einer Leiterplatte.

Oft besteht die Forderung, bestimmte auf einer Leiterplatte angeordnete Bauteile besonders elektromagnetisch abzuschirmen. Dazu werden diese Bauteile mittels eines Schirmdeckels, welcher auf die Leiterplatte aufgeschraubt wird, abgeschirmt; (vgl. JP-A-8 116 195 oder DE-U-6 607 180). In vielen Fällen kann in kleinen Geräten, z. B. in Mobilfunkgeräten, aus Platzgründen keine Verschraubung angebracht werden, da der dafür notwendige Platz unter bzw. hinter der Leiterplatte fehlt.

Aufgabe der vorliegenden Erfindung ist es daher, eine Befestigungsvorrichtung der oben genannten Art anzugeben, bei welcher auf der Rückseite der Leiterplatte möglichst wenig Raum beansprucht wird, anzugeben.

Diese Aufgabe wird erfindungsgemäß für eine Befestigungsvorrichtung der eingangs genannten Art dadurch gelöst, daß der Schirmdeckel mittels einer Blattfeder und eines Spannstifts auf die Leiterplatte aufgedrückt ist, wobei der Spannstift mit seinen Endbereichen sowohl mit der Leiterplatte als auch mit der Blattfeder in Eingriff steht.

Bei der erfindungsgemäßen Vorrichtung zur Befestigung eines Schirmdeckels auf einer Leiterplatte wird zur Befestigung nicht der unter bzw. hinter der Leiterplatte liegende Raum benötigt.

Eine zweckmäßige Ausgestaltung der erfindungsgemäßen Vorrichtung ist dadurch gekennzeichnet, daß der Spannstift an seinen Enden umlaufende Nuten aufweist, daß in der Leiterplatte eine Öffnung mit einem sich daran anschließenden Schlitz, in welchen der Spannstift mit seiner unteren Nut einschiebbar ist vorgesehen ist, und daß die obere Nut des Spannstifts bei aufgelegtem Schirmdeckel durch eine dafür vorgesehene Öffnung aus dem Schirmdeckel hervorragt und mit einer Ausnehmung der vorgespannten Blattfeder in Eingriff steht. Diese Ausgestaltung zeichnet sich durch einen besonders einfachen Aufbau aus.

Die vorliegende Erfindung wird nachstehend anhand eines in der Zeichnung dargestellten Ausführungsbeispiels näher beschrieben.

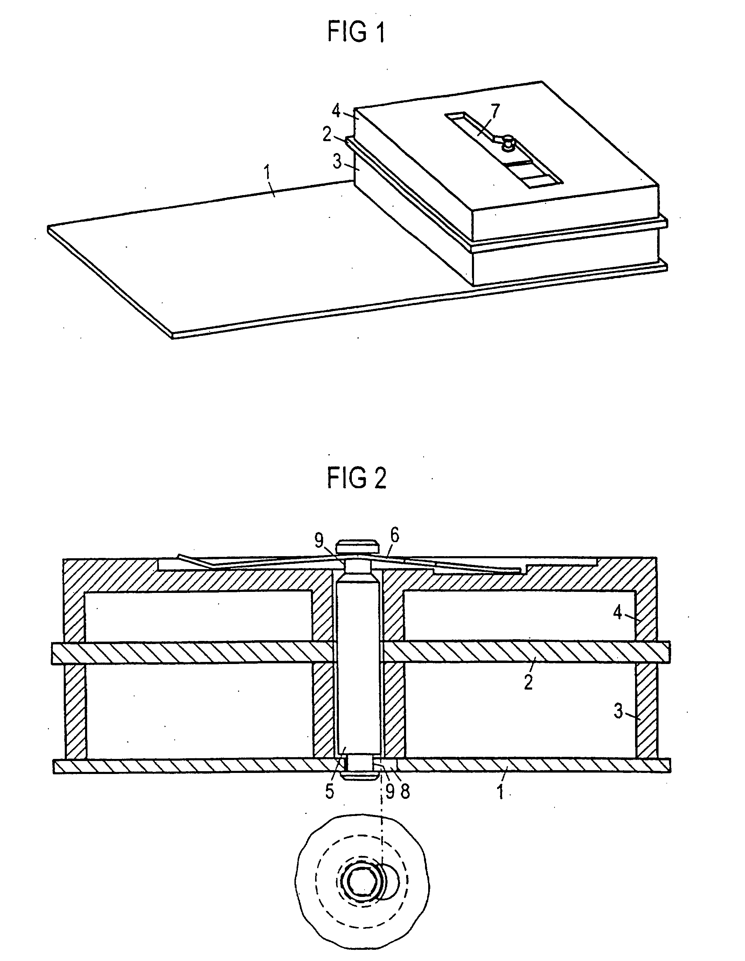

Es zeigen
Figur 1 eine perspektivische Ansicht einer Leiterplatte mit einem gemäß der Erfindung befestigten Schirmdeckel,
Figur 2 einen Querschnitt durch einen gemäß der Erfindung auf einer Leiterplatte befestigten Schirmdeckel, und

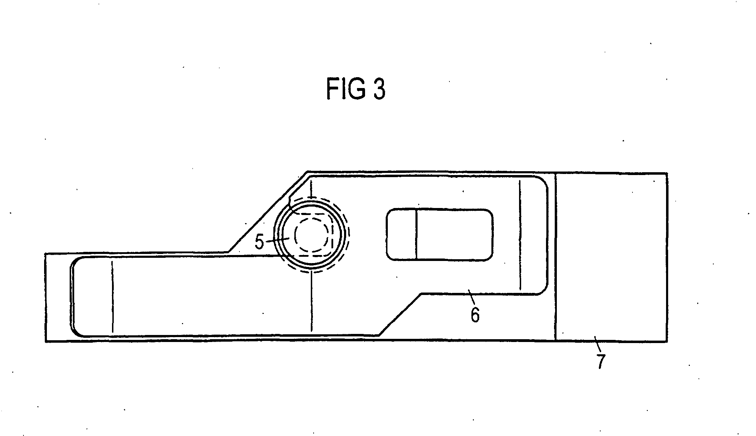

Figur 3 eine teilweise Aufsicht auf den gemäß der Erfindung befestigten Schirmdeckel.

Oft besteht die Forderung bestimmte auf einer Leiterplatte 1 angeordnete Bauteile besonders elektromagnetisch abzuschirmen. Dazu werden diese Bauteile mittels eines Schirmdeckels, welcher auf die Leiterplatte aufgeschraubt wird, besonders abgeschirmt. In vielen Fällen, z. B. in Mobilfunkgeräten, kann aus Platzgründen keine Verschraubung angebracht werden, da der dafür notwendige Platz unter bzw. hinter der Leiterplatte fehlt.

Bei der erfindungsgemäßen Befestigungsvorrichtung ist ein Spannstift 5 vorgesehen, welcher an seinen beiden Enden umlaufende Nuten 9 aufweist. Die Leiterplatte 1 weist ungefähr in der Mitte des abzuschirmenden Bereichs ein Einführungsloch 8 für den Spannstift 5 auf. Dieses Einführungsloch 8 besteht im wesentlichen aus einer Öffnung durch welche der Spannstift 5 hindurchgesteckt werden kann, und einem sich daran anschließenden Schlitz, in welchen der Spannstift 5 mit seiner unteren Nut eingeführt wird, so daß der Spannstift in vertikaler Richtung festgelegt ist. Es ist selbstverständlich, daß der Abstand zwischen der Nut 9 und dem freien unteren Ende des Spannstiftes 5 minimal ist, so daß dafür kaum Platz unterhalb der Leiterplatte 1 benötigt wird. Darüberhinaus wird der Platz hinter bzw. unter der Leiterplatte bei der Anbringung des Schirmdeckels nicht benötigt.

Im dargestellten Ausführungsbeispiel ist zwischen dem Schirmdeckel 4 und der Leiterplatte 1 noch ein Schirmrahmen 3 vorgesehen, wobei zwischen Schirmrahmen 3 und Schirmdeckel 4 eine Zusatzleiterplatte 2 angebracht. Hier ist festzustellen, daß der Schirmrahmen 3 nicht erfindungswesentlich ist.

Wie der Schirmdeckel 4 so besitzt auch der Schirmrahmen 3 in der Mitte eine Führung für den Spannstift 5, so daß dieser gegen eine unbeabsichtigte seitliche Bewegung geschützt ist.

Am oberen Ende des Spannstiftes 5 ist ebenfalls eine umlaufende Nut 9 angebracht, in welche die Ausnehmung einer Blattfeder 6 eingeführt wird. Die in die Nut eingreifende Ausnehmung der Blattfeder 6 ist so ausgeführt, daß im eingeschobenen Zustand der Blattfeder 6 sich der Eingriff der Nut des Spannstiftes 5 mit der Blattfeder 6 im wesentlichen in der Mitte der Blattfeder 6 befindet. Die Blattfeder 6 ist so ausgebildet, daß sich ihre beiden Enden auf dem Schirmrahmen 3 abstützen. Damit ist nach dem Aufschieben der Blattfeder 6 auf das Ende des Spannstifts 5 der Schirmdeckel 4 auf der Leiterplatte 1 befestigt.

Hierbei ist es von Vorteil, daß durch die Ausbildung'der Blattfeder 6 eine definierte Andruckkraft auf den Schirmdeckel ausgeübt wird. Es wird also verhindert, daß es durch Aufbringen einer zu großen Andruckkraft zu einer Zerstörung der Leiterplatte 1 oder des Schirmdeckels 4 kommt.

Dabei erfolgt der Andruck des Schirmrahmens 3 auf die Leiterplatte 1 aufgrund der Blattfeder mit einem bestimmten vorgegebenen Druck. Es wird bei der erfindungsgemäßen Befestigungsvorrichtung also vermieden, daß durch das Aufbringen einer zu hohen Kraft bei der Befestigung des Schirmrahmens 3 auf der Leiterplatte 1 eine Zerstörung entweder des Schirm-deckels 4 oder der Leiterplatte 1 erfolgt.

Zur Lagesicherung der Blattfeder 6 kann diese in eine Ausbuchtung 7 eingelegt werden, welche sich auf der Oberfläche des Schirmdeckels 4 befindet.

## Patentansprüche

1. Vorrichtung zum Befestigen eines Schirmdeckels auf einem abzuschirmenden Bereich einer Leiterplatte,
**dadurch gekennzeichnet,**
**daß** der Schirmdeckel (4) mittels einer Blattfeder (6) und eines Spannstifts (5) auf die Leiterplatte (1) aufgedrückt ist, wobei der Spannstift (5) mit seinen Endbereichen sowohl mit der Leiterplatte (1). als auch mit der Blattfeder (6) in Eingriff steht.

2. Vorrichtung nach Anspruch 1,
**dadurch gekennzeichnet,**
**daß** der Spannstift (5) an seinen Enden umlaufende Nuten (9) aufweist, daß in der Leiterplatte (1) eine Öffnung (8) mit einem sich daran anschließenden Schlitz, in welchen der Spannstift (5) mit seiner unteren Nut (9) einschiebbar ist, vorgesehen ist, und daß die obere Nut (9) des Spannstifts (5) bei aufgelegtem Schirmdeckel (4) durch eine dafür vorgesehene Öffnung aus dem Schirmdeckel (4) hervorragt und mit'einer Ausnehmung der vorgespannten Blattfeder (6) in Eingriff steht.

3. Vorrichtung nach Anspruch 1 oder 2,
**dadurch gekennzeichnet,**
**daß** der Schirmdeckel (4) eine Führung für den Spannstift (5) besitzt.

## Claims

1. Device for fastening a protective cover plate on a region of a printed-circuit board to be shielded, **characterized in that** the protective cover plate (4) is pressed onto the printed-circuit board (1) by means of a leaf spring (6) and a tensioning pin (5), the tensioning pin (5) being in engagement by its end regions both with the printed-circuit board (1) and with the leaf spring (6).

2. Device according to Claim 1, **characterized in that** the tensioning pin (5) has peripheral grooves (9) at its ends, **in that** an opening (8) with an adjoining slit, into which the tensioning pin (5) can be pushed with its lower groove (9), is provided in the printed-circuit board (1), and **in that** the upper groove (9) of the tensioning pin (5) protrudes out of the protective cover plate (4) through an opening provided for this purpose and is in engagement with a recess of the pretensioned leaf spring (6) when the protective cover plate (4) is in place.

3. Device according to Claim 1 or 2, **characterized in that** the protective cover plate (4) has a guide for the tensioning pin (5).

## Revendications

1. Dispositif pour fixer un couvercle de blindage sur une région à protéger d'une carte imprimée,
**caractérisé en ce que** le couvercle (4) de blindage est engagé par pression sur la carte (1) imprimée au moyen d'un ressort (6) à lame et d'une broche (5) de serrage, la broche (5) de serrage étant en engagement, par ses régions terminales, tant avec la carte (1) imprimée qu'avec le ressort (6) à lame.

2. Dispositif suivant la revendication 1, **caractérisé en ce que** la broche (5) de serrage comporte à ses extrémités des rainures (9) entourantes, **en ce qu'**il est prévu dans la carte (1) imprimée une ouverture (8) à laquelle se raccorde une fente dans laquelle la broche (5) de serrage peut être enfilée par sa rainure (9) inférieure, et **en ce que** la rainure (9) supérieure de la broche (5) de serrage, lorsque le couvercle (4) de blindage est posé, dépasse du couvercle (4) de blindage par une ouverture prévue à cet effet et est en prise avec un évidement du ressort (6) à lame précontraint.

3. Dispositif suivant la revendication 1 ou 2, **caractérisé en ce que** le couvercle (4) de blindage possède un guidage pour la broche (5) de serrage.
